# EUROPÄISCHE PATENTANMELDUNG

(11) **EP 1 788 232 A1**
(43) Veröffentlichungstag der Anmeldung: **23.05.2007**
(21) Anmeldenummer: 05025070.3
(22) Anmeldetag: 16.11.2005
(51) Int. Cl.: F02M 59/46, H01L 41/053, F02M 51/06, F02M 63/00

(54) **Aktorvorrichtung und Fluidinjektor**

(71) Anmelder: SIEMENS AKTIENGESELLSCHAFT, 80333 München (DE)
(72) Erfinder: Freudenberg, Hellmut, 93080 Grossberg (DE); Hamann, Christoph, Dr., 93107 Thalmassing (DE); Jovovic, Dejan, 93049 Regensburg (DE); Kronberger, Maximlian, Dr., 93053 Regensburg (DE); Pirkl, Richard, 93055 Regensburg (DE)

(57) **Zusammenfassung**

Ein Fluidinjektor umfasst ein Gehäuse (1) mit einer Gehäuseausnehmung (3) in die eine Aktorvorrichtung eingebracht ist. Die Aktorvorrichtung hat einen rohrförmigen Gehäusekörper (21), einen Festkörperaktuator (19), der in den rohrförmigen Gehäusekörper eingebracht ist. Sie hat ferner einen partikelförmigen Füllstoff (25), der in einen Zwischenraum (23) radial zwischen dem Gehäusekörper (21) und dem Festkörperaktuator (19) eingebracht ist.

## Beschreibung

Die Erfindung betrifft eine Aktorvorrichtung und einen Fluidinjektor, insbesondere für Brennkraftmaschinen, wo er angeordnet sein kann zum Zumessen von Fluid in einen Ansaugtrakt oder direkt in die Brennkammer eines jeweiligen Zylinders der Brennkraftmaschine.

Um immer strengeren Vorschriften bezüglich der Abgasemissionen von Brennkraftmaschinen Rechung zu tragen, müssen die Fluidinjektoren so ausgebildet sein, dass sie Fluids sehr präzise zumessen können. In diesem Zusammenhang werden mehr und mehr Fluidinjektoren mit Aktuatorvorrichtungen mit Festkörperaktuatoren ausgerüstet, insbesondere mit piezoelektrischen Aktoren. Im Hinblick auf ein Verbessern des Verbrennungsprozesses bezüglich der Erzeugung von unerwünschten Schadstoffemissionen ist es vorteilhaft, wenn der entsprechende Fluidinjektor geeignet ist zum Zumessen von Fluid unter sehr hohem Druck. Der Druck beträgt beispielsweise im Falle von Benzinmotoren bis zu in etwa 200 bar und im Falle von Dieselmotoren bis zu in etwa 2000 bar. Durch derartig hohe Drücke beim Zumessen des Kraftstoffs kann insbesondere auch eine Bildung von Rußpartikeln wirkungsvoll reduziert werden.

Aus der WO 02/061856 ist eine piezoelektrische Aktuatoranordnung bekannt, die angeordnet ist innerhalb eines rohrförmigen Teils, wobei eine innere Oberfläche des rohrförmigen Teils und eine äußere Oberfläche des piezoelektrischen Elements zusammen eine Kammer definieren, in die ein Füllmaterial eingebracht ist und zwar derart, dass eine Kraft hervorgerufen durch den Kraftstoffdruck in einem Injektorakkumulatorvolumen auf ein piezoelektrisches Element über den rohrförmigen Körper und das Füllmaterial einwirkt, wenn die Aktuatoranordnung in Benutzung ist. Das Füllmaterial kann von relativ geringer Viskosität sein, die ausreichend ist um sicherzustellen, dass eine im Wesentlichen gleichförmige Verteilung einer hydrostatischen Last auf dem Piezostapel erfolgt, wenn Kraftstoffdruck einwirkt. Das Füllmaterial muss eine gute Adhäsion zwischen dem rohrförmigen Körper und dem Piezostapel gewährleisten. Das Füllmaterial muss auch so ausgebildet sein, dass es im Wesentlichen undurchlässig ist für Kraftstoff unter den hohen Kraftstoffdrücken.

Aus der EP 0 995 901 B1 ist ein Kraftstoffventil bekannt, das einen Kraftstoffeintritt aufweist, der so angeordnet ist, dass er bei Benutzung Kraftstoff unter hohem Druck von einer Quelle des unter Druck stehenden Kraftstoffs aufnimmt. Das Kraftstoffeinspritzventil weist ferner einen Austritt auf und ein piezoelektrisches Betätigungselement, das betriebsfähig ist, um einen Steuerkolben zu bewegen, um den Kraftstoffdruck innerhalb einer Steuerungskammer zu modifizieren. Das Kraftstoffventil weist ein Speichervolumen auf, das zwischen dem Eintritt und dem Austritt angeordnet ist. Das piezoelektrische Betätigungselement ist innerhalb des Speichervolumens angeordnet. Weitere piezoelektrische Aktuatoren sind aus der DE 102 30 032A1, der DE 101 49 914A1, der DE 198 56 185 A1 und der EP 1080305B1 bekannt.

Bezüglich eines ersten Aspekts ist die Aufgabe der Erfindung eine Aktorvorrichtung zu schaffen, die einen präzisen Betrieb ermöglicht. Bezüglich eines zweiten Aspekts ist die Aufgabe der Erfindung einen Fluidinjektor zu schaffen, der einen präzisen Betrieb ermöglicht.

Die Aufgabe wird gelöst durch die Merkmale der unabhängigen Patentansprüche. Vorteilhafte Ausgestaltungen der Erfindung sind in den Unteransprüchen gekennzeichnet.

Die Erfindung zeichnet sich gemäß eines ersten Aspekts aus durch eine Aktorvorrichtung mit einem rohrförmigen Gehäusekörper, einem Festkörperaktuator, der in den rohrförmigen Gehäusekörper eingebracht ist. Ferner ist ein partikelförmiger Füllstoff in einen Zwischenraum radial zwischen dem Gehäusekörper und dem Festkörperaktuator eingebracht. Der Zwischenraum bildet insbesondere eine Kammer. Der partikelförmige Füllstoff zeichnet sich dadurch aus, dass er Eigenschaften von Flüssigkeiten bezüglich der Druckübertragung hat, insbesondere eine Übertragung einer axial einwirkenden Kraft auch in radialer Richtung und so insbesondere in radialer Richtung auf den Festkörperaktuator. Auf diese Weise kann ein gewünschtes Ansprechverhalten der Aktorvorrichtung auch bei einem Einwirken von hohem Druck, insbesondere in einem Fluid, von außen auf die Aktorvorrichtung reproduzierbar eingestellt sein. Besonders bevorzugt ist der rohrförmige Gehäusekörper aus Metall ausgebildet. Er hat bevorzugt mindestens eine der folgenden Eigenschaften:
- Fluid, das gegebenenfalls die Aktorvorrichtung teilweise umgibt, von einem Eindringen in die Aktorvorrichtung zuverlässig abzuhalten;
- eine notwendige Vorspannung für den Festkörperaktuator aufzubauen ;
- eine geringe Federsteifigkeit.

Gemäß einer vorteilhaften Ausgestaltung der Erfindung haben die Partikel des partikelförmigen Füllstoffs eine Steifigkeit zwischen der von Glas bis zu der von Keramik. Es kann so zu einem hohen Grad sichergestellt werden, dass Partikel nicht zu stark eingedrückt werden und so auch bei hohen Drücken eine gute Relativbewegung der einzelnen Partikel zueinander möglich ist. Dies hat den vorteilhaften Effekt, dass eine axiale Längenänderung des Festkörperaktuators im Wesentlichen ungehindert möglich ist und zum Anderen eine axial einwirkende Kraft auch in radialer Richtung durch den partikelförmigen Füllstoff übertragen wird und somit auch in radialer Richtung auf den Festkörperaktuator übertragen wird.

Gemäß einer weiteren vorteilhaften Ausgestaltung der Erfindung beträgt die Korngröße der Partikel zwischen einem Mikrometer und einem Millimeter. Auf diese Weise kann eine gute Beweglichkeit der einzelnen Partikel erreicht werden. Ferner kann sichergestellt werden, dass ausreichend viele Stützpunkte, das heißt Kontaktpunkte der Partikel mit dem Gehäusekörper vorhanden sind.

In diesem Zusammenhang ist es besonders vorteilhaft, wenn die Korngröße mindestens 100 Mikrometer beträgt. Auf diese Weise kann ein unerwünschtes Kompaktieren des partikelförmigen Füllstoffs sehr zuverlässig verhindert werden und so eine Bewegungshemmung des Festkörperaktuators in axialer Richtung hervorgerufen durch kompaktierten Füllstoff vermieden werden. Dieser Vorteil tritt besonders bei Anwendungen der Aktorvorrichtung in Fluidinjektoren zum Vorschein, beispielsweise bei einem Einsatz in einem Kraftfahrzeug.

Gemäß einer weiteren vorteilhaften Ausgestaltung der Erfindung sind die Partikel kugelförmig ausgebildet. Kugelförmige Partikel haben die Eigenschaft aufeinander abrollen zu können, was zur Folge hat, dass die axiale Bewegung des Festkörperaktuators nur unwesentlich durch den partikelförmigen Füllstoff bei gewünschten axialen Bewegungen des Festkörperaktuators nur unwesentlich gehemmt wird. Ein Verhaken der Partikel ist durch die Kugelform nahezu ausgeschlossen, dies gilt insbesondere für ein Verhaken der Partikel auf der Oberfläche des Festkörperaktuators.

Gemäß einer weiteren vorteilhaften Ausgestaltung der Erfindung ist der partikelförmige Füllstoff elektrisch isolierend. So kann ein Funkenüberschlag bei dem Festkörperaktuator weitgehend vermieden werden und der Festkörperaktuator muss nicht unbedingt zusätzlich elektrisch isoliert sein.

Gemäß einer weiteren vorteilhaften Ausgestaltung der Erfindung ist der partikelförmige Füllstoff eine Keramik. Dies hat den Vorteil, dass Keramik in der Regel auch einen ähnlichen spezifischen Wärmeausdehnungskoeffizienten hat wie typischerweise der des Festkörperaktuators.

Besonders bevorzugt ist der partikelförmige Füllstoff Zirkonoxid. Insbesondere bei Festkörperaktuatoren, die als Piezoaktoren ausgebildet sind, sind so regelmäßig sehr ähnliche Materialeigenschaften zwischen dem Festkörperaktuator und dem partikelförmigen Füllstoff gegeben. Ferner ist Zirkonoxid sehr leicht erhältlich.

Gemäß einer weiteren vorteilhaften Ausgestaltung der Erfindung ist der partikelförmige Füllstoff Aluminiumoxid oder Siliziumoxid, auch diese Stoffe sind sehr gut verfügbar.

Gemäß einer weiteren vorteilhaften Ausgestaltung der Erfindung ist der rohrförmige Gehäusekörper ein Wellrohr. Dies hat gute Dichteigenschaften und ermöglicht axiale Beweglichkeit des Festkörperaktuators. Gegebenenfalls kann der rohrförmige Gehäusekörper in seiner Minimalversion auch eine dünne Folie sein.

Gemäß eines zweiten Aspekts zeichnet sich die Erfindung aus durch einen Fluidinjektor mit einem Gehäuse mit einer Gehäuseausnehmung in die Aktorvorrichtung gemäß des ersten Aspekts eingebracht ist.

Gemäß einer vorteilhaften Ausgestaltung des zweiten Aspekts bildet ein radialer Zwischenraum zwischen der Aktorvorrichtung und einer Wandung des Gehäuses eine Fluidzuführung. So kann einerseits eine kompakte Zuführung des Fluids gewährleistet werden und andererseits die Aktorvorrichtung mit einem geeigneten hohen Druck des Fluids beaufschlagt werden.

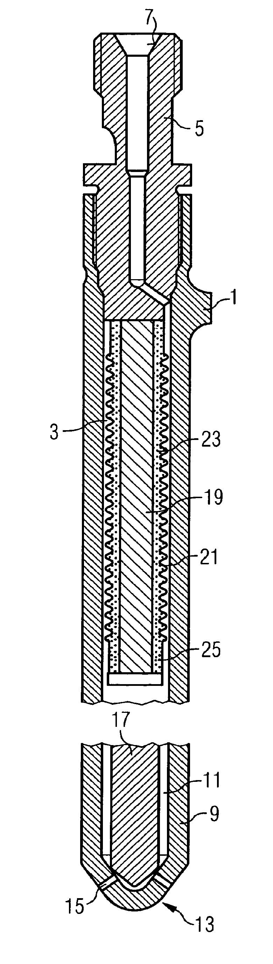

Ausführungsbeispiele der Erfindung sind im Folgenden anhand der schematischen Zeichnungen erläutert. Die einzige Figur zeigt einen Fluidinjektor mit der Aktorvorrichtung.

Ein Fluidinjektor kann ausgebildet sein als ein Kraftstoffinjektor, der geeignet ist zum Zumessen von Kraftstoff in eine Benzin- oder eine Dieselbrennkraftmaschine.

Der Fluidinjektor umfasst ein Gehäuse 1, das eine Gehäuseausnehmung 3 hat, die sich in axialer Richtung erstreckt. In einem axialen Endbereich der Gehäuseausnehmung 3 ist ein Fluidversorgungs-Verbindungsteil 5 eingebracht und an dem Gehäuse 1 fixiert, bevorzugt mittels Schweißens. Das Fluidversorgungs-Verbindungsteil 5 hat eine Fluidversorgungsausnehmung 7, die in einem montierten Zustand des Fluidinjektors hydraulisch mit einer Fluidversorgung gekoppelt ist. Die Fluidversorgungsausnehmung 7 mündet in die Gehäuseausnehmung 3.

Das Gehäuse 1 ist ferner mit einem Düsenkörper 9 gekoppelt. Der Düsenkörper 9 kann beispielsweise Teil einer Düsenbaugruppe sein, die gegebenenfalls noch weitere Körper umfasst und die dann mit dem Gehäuse 1 gekoppelt ist, so zum Beispiel durch eine Schraubverbindung. Sie kann alternativ jedoch auch beispielsweise durch Schweißen mit dem Gehäuse 1 verbunden sein. Der Düsenkörper 9 ist somit mit dem Gehäuse 1 gekoppelt.

Der Düsenkörper 9 umfasst eine Düsenkuppe 13 und eine sich axial erstreckende Düsenkörperausnehmung 11. In dem Bereich der Düsenkuppe 13 sind Spritzlöcher 15, bevorzugt eines Spritzlochkreises ausgebildet, die die Düsenkuppe nach außen durchdringen. Ferner ist in der Düsenkörperausnehmung 11 eine Düsennadel 17 angeordnet, welche in einer Schließposition ein Zumessen von Fluid durch das Spritzloch 15 unterbindet und ansonsten ein Zumessen des Fluids durch das Spritzloch 15 frei gibt.

Ein Bereich radial zwischen der Düsennadel 17 und einer Wandung der Düsenkörperausnehmung 11 ist hydraulisch gekoppelt mit der Fluidversorgungsausnehmung 7. Der Düsennadel 17 ist ferner eine nicht dargestellte Rückstellfeder zugeordnet, die über eine Federauflage mechanisch gekoppelt ist mit der Düsennadel 17 und die diese ohne das Einwirken weiterer Kräfte in die Schließposition der Düsennadel 17 vorspannt. Ferner umfasst die Düsennadel 17 noch hydraulisch wirksame Flächen über die, hervorgerufen durch den Druck des Fluids, Kräfte auf die Düsennadel 17 eingekoppelt werden können, die die Position der Düsennadel 17 beeinflussen.

Zum Einstellen der Position der Düsennadel 17 ist ferner eine Aktorvorrichtung vorgesehen, die in der Gehäuseausnehmung 3 angeordnet ist. Die Aktorvorrichtung umfasst einen Festkörperaktuator 19, der bevorzugt als Piezoaktuator ausgebildet ist. Der Piezoaktuator umfasst einen Stapel an Piezoelementen. Er kann jedoch auch als ein anderer dem Fachmann für diesen Zweck bekannter Festkörperaktuator ausgebildet sein.

Der Festkörperaktuator 19 ist in radialer Richtung entlang seiner axialen Erstreckung von einem rohrförmigen Gehäusekörper 21 umgeben, der bevorzugt metallisch ausgebildet ist und beispielsweise als ein Wellrohr oder auch eine dünne Metallfolie ausgebildet ist. Bevorzugt ist der rohrförmige Gehäusekörper 21 an axialen Enden des Festkörperaktuators 19 an jeweiligen Platten fixiert und ist im Zusammenwirken mit den Platten so ausgebildet, dass er eine Vorspannung für den Festkörperaktuator 19 erzeugt. Ferner ist der rohrförmige Gehäusekörper 21 bevorzugt so ausgebildet, dass er den Festkörperaktuator 19 von dem den rohrförmigen Gehäusekörper 21 radial nach außen umgebenden Medium dichtend trennt. Ferner hat der rohrförmige Gehäusekörper 21 bevorzugt eine geringe Federsteifigkeit.

In einen Zwischenraum 23 radial zwischen dem rohrförmigen Gehäusekörper 21 und dem Festkörperaktuator 19 ist ein partikelförmiger Füllstoff 25 eingebracht. Die Partikel des partikelförmigen Füllstoffs 25 haben bevorzugt eine Steifigkeit zwischen derjenigen von Glas bis zu der von Keramik. Bevorzugt ist der partikelförmige Füllstoff 25 auch elektrisch isolierend. Auf diese Weise kann ein Funkenüberschlag an dem Festkörperaktuator 19 wirkungsvoll verhindert werden. Als besonders geeignet hat es sich erwiesen wenn der Füllstoff Keramik ist, auch Glas hat sich als tauglich erwiesen. Als besonders geeignete partikelförmige Füllstoffe kommen beispielsweise Aluminiumoxid, Siliziumoxid oder Zirkonoxid in Frage. Zirkonoxid zeichnet sich dadurch aus, dass es in der Regel sehr ähnliche Materialeigenschaften wie der Festkörperaktuator 19 hat. Bevorzugt ist die Korngröße der Partikel des partikelförmigen Füllstoffs so vorgegeben, dass sie in etwa zwischen einem Mikrometer und einem Millimeter beträgt, das heißt insbesondere in der jeweiligen Größenordnung zwischen einem Mikrometer und einem Millimeter liegt. Bei der Wahl der Korngröße ist insbesondere auf eine gute Beweglichkeit der Partikel während des Betriebs des Festkörperaktuators 19 abzustellen um so eine ungehinderte axiale Bewegung des Festkörperaktuators 19 zu ermöglichen. Darüber hinaus kann jedoch über die Partikel eine in axialer Richtung auf die Aktuatorvorrichtung einwirkende Kraft, zum Beispiel hervorgerufen durch den Druck des Fluids in der Gehäuseausnehmung 3, auch in radialer Richtung, also insbesondere in radialer Richtung auf den Festkörperaktuator 19, übertragen werden. Dies hat dann ein gewünschtes Übertragungsverhalten des Festkörperaktuators 19 zur Folge.

Durch den Druck des Fluids in der Gehäuseausnehmung 3 wird auch in radialer Richtung auf den rohrförmigen Gehäusekörper 21 eine Kraft ausgeübt. Bevorzugt ist der rohrförmige Gehäusekörper 21 auch so ausgebildet, dass er diese in radialer Richtung wirkende Kraft nach innen überträgt und so entsprechend die radiale Kraft auf den partikelförmigen Füllstoff 25 einwirkt und von diesem auf den Festkörperaktuator 19 übertragen wird. Darüber hinaus ist durch die Wahl der Korngröße des partikelförmigen Füllstoffs 25 möglichst sicherzustellen, dass genügend viele Stützpunkte zwischen dem partikelförmigen Füllstoff und dem rohrförmigen Gehäusekörper 21 vorhanden sind. Insbesondere für den Einsatz bei dem Fluidinjektor haben sich in diesem Zusammenhang Korngrößen von mindestens 100 Mikrometern, also in etwa 100 Mikrometer beziehungsweise in der Größenordnung von 100 Mikrometer als besonders geeignet erwiesen.

Eine besonders gute Relativbewegung der einzelnen Partikel zueinander lässt sich erreichen, wenn die Partikel kugelförmig sind. Die Partikel können dann aufeinander abrollen und somit hat der partikelförmige Füllstoff im Hinblick auf das Übertragen von Druck nahezu die Eigenschaft einer Flüssigkeit. Darüber hinaus kann durch kugelförmige Partikel ein Verhaken der Partikel nahezu ausgeschlossen werden, insbesondere an der Oberfläche des Festkörperaktuators 19.

Bei Einsatz des Aktuatorkörpers in einem Fluidinjektor ist vorzugsweise ein mechanischer Hubumkehrer zu Übertragung der Auslenkung der Aktuatorvorrichtung auf eine Düsennadel des Ventilsitzes des Fluidinjektors vorgesehen, wobei zwischen Aktorvorrichtung und Hubumkehrer ein hydraulisches Ausgleichselement mit einem Übersetzungsverhältnis von etwa 1:1 zum Ausgleich von unerwünschten statischen, beispielsweise temperaturbedingten oder alterungsbedingten Längenänderungen des Aktuatorkörpers vorgesehen ist.

Weiterhin ist die Aktuatorvorrichtung zumindest in einem Teil ihrer axialen Länge mit hohem Kraftstoffdruck, vorzugsweise von 1000 bis 2500 bar belastbar.

## Patentansprüche

1. Aktuatorvorrichtung mit einem rohrförmigen Gehäusekörper (21), einem Festkörperaktuator (19), der in den rohrförmigen Gehäusekörper (21) eingebracht ist, und einem partikelförmigen Füllstoff (25), der in einem Zwischenraum (23) radial zwischen dem Gehäusekörper (21) und dem Festkörperaktuator (19) eingebracht ist.

2. Aktuatorvorrichtung nach Anspruch 1, bei der die Partikel des partikelförmigen Füllstoffs (25) eine Steifigkeit zwischen der von Glas bis zu der von Keramik haben.

3. Aktuatorvorrichtung nach einem der vorstehenden Ansprüche, bei der die Korngröße der Partikel des partikelförmigen Füllstoffs (25) zwischen einem Mikrometer und einem Millimeter beträgt.

4. Aktuatorvorrichtung nach Anspruch 3, bei der die Korngröße der Partikel des partikelförmigen Füllstoffs (25) mindestens 100 Mikrometer beträgt.

5. Aktuatorvorrichtung nach einem der vorstehenden Ansprüche, bei der die Partikel des partikelförmigen Füllstoffs (25) kugelförmig sind.

6. Aktuatorvorrichtung nach einem der vorstehenden Ansprüche, bei der der partikelförmige Füllstoff (25) elektrisch isolierend ist.

7. Aktuatorvorrichtung nach einem der vorstehenden Ansprüche, bei dem der partikelförmige Füllstoff (25) eine Keramik ist.

8. Aktuatorvorrichtung nach Anspruch 7, bei der der partikelförmige Füllstoff (25) Zirkonoxid ist.

9. Aktuatorvorrichtung nach Anspruch 7, bei der der partikelförmige Füllstoff (25) Aluminiumoxid oder Siliziumoxid ist.

10. Aktuatorvorrichtung nach einem der vorstehenden Ansprüche, bei der der rohrförmige Gehäusekörper (21) ein Wellrohr ist.

11. Fluidinjektor mit einem Gehäuse (1) mit einer Gehäuseausnehmung (3), in die die Aktorvorrichtung nach einem der vorstehenden Ansprüche eingebracht ist.

12. Fluidinjektor nach Anspruch 11, bei dem ein radialer Zwischenraum zwischen der Aktorvorrichtung und einer Wandung des Gehäuses (1) eine Fluidzuführung bildet.

13. Fluidinjektor nach Anspruch 11 oder 12, bei dem ein mechanischer oder hydraulischer Hubumkehrer zu Übertragung der Auslenkung der Aktuatorvorrichtung auf eine Düsennadel vorgesehen ist, wobei zwischen Aktorvorrichtung und Hubumkehrer ein hydraulisches Ausgleichselement vorgesehen ist.

14. Fluidinjektor nach einem der Ansprüche 11 bis 13, wobei die Aktuatorvorrichtung zumindest in einem Teil ihrer axialen Länge mit hohem Kraftstoffdruck, vorzugsweise von 1000 bis 2500 bar oder im Wesentlichen dem Einspritzdruck des Fluidinjektors belastbar ist.

15. Fluidinjektor nach einem der Ansprüche 11 bis 14, wobei das Fluid Kraftstoff, bevorzugt Diesel oder Benzin ist.
